(19) Europäisches Patentamt / European Patent Office / Office européen des brevets

(11) **EP 3 510 641 B1**

(12) **EUROPEAN PATENT SPECIFICATION**

(45) Date of publication and mention
of the grant of the patent:
**28.09.2022 Bulletin 2022/39**

(21) Application number: **17842409.9**

(22) Date of filing: **05.09.2017**

(51) International Patent Classification (IPC):
*H01L 33/00* (2010.01)   *H01L 33/02* (2010.01)
*H01L 33/34* (2010.01)

(52) Cooperative Patent Classification (CPC):
**H01L 33/0004; H01L 33/025; H01L 33/34**

(86) International application number:
**PCT/ZA2017/050052**

(87) International publication number:
**WO 2018/049434 (15.03.2018 Gazette 2018/11)**

(54) **650 NM SILICON AVALANCHE LIGHT EMITTING DIODE**

SILICIUM-AVALANCHE-LEUCHTDIODE MIT 650 NM

DIODE ÉLECTROLUMINESCENTE À AVALANCHE AU SILICIUM DE 650 NM

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **06.09.2016 ZA 201606148**

(43) Date of publication of application:
**17.07.2019 Bulletin 2019/29**

(73) Proprietor: **University Of South Africa
Unisa, Pretoria (ZA)**

(72) Inventor: **SNYMAN, Lukas, Willem
Faerie Glen
0081 Pretoria/ZA (ZA)**

(74) Representative: **Baur & Weber Patentanwälte
PartG mbB
Rosengasse 13
89073 Ulm (DE)**

(56) References cited:
**US-A1- 2012 153 864    US-A1- 2012 153 864
US-A1- 2012 170 942    US-A1- 2012 170 942**

- SNYMAN L W ET AL: "Stimulation of 450, 650 and 850-nm optical emissions from custom designed silicon LED devices by utilizing carrier energy and carrier momentum engineering", PROCEEDINGS OPTICAL DIAGNOSTICS OF LIVING CELLS II, SPIE, US, vol. 10036, 3 February 2016 (2016-02-03), pages 1003603-1003603, XP060081562, ISSN: 0277-786X, DOI: 10.1117/12.2264197 ISBN: 978-1-5106-1723-0
- SNYMAN LUKAS W ET AL: "Higher Intensity SiAvLEDs in an RF Bipolar Process Through Carrier Energy and Carrier Momentum Engineering", IEEE JOURNAL OF QUANTUM ELECTRONICS, IEEE SERVICE CENTER, PISCATAWAY, NJ, USA, vol. 51, no. 7, 1 July 2015 (2015-07-01), pages 1-10, XP011584375, ISSN: 0018-9197, DOI: 10.1109/JQE.2015.2427036 [retrieved on 2015-06-12]
- SNYMAN L W ET AL: "Stimulation of 450, 650 and 850-nm optical emissions from custom designed silicon LED devices by utilizing carrier energy and carrier momentum engineering", PROCEEDINGS OF SPIE; [PROCEEDINGS OF SPIE ISSN 0277-786X VOLUME 10524], SPIE, US, vol. 10036, 3 February 2016 (2016-02-03), pages 1003603-1003603, XP060081562, DOI: 10.1117/12.2264197 ISBN: 978-1-5106-1533-5

- **SNYMAN LUKAS W ET AL: "Higher Intensity SiAvLEDs in an RF Bipolar Process Through Carrier Energy and Carrier Momentum Engineering", IEEE JOURNAL OF QUANTUM ELECTRONICS, IEEE SERVICE CENTER, PISCATAWAY, NJ, USA, vol. 51, no. 7, 1 July 2015 (2015-07-01), pages 1-10, XP011584375, ISSN: 0018-9197, DOI: 10.1109/JQE.2015.2427036 [retrieved on 2015-06-12]**

**Description**

**INTRODUCTION**

This invention relates to Silicon avalanche LEDs, in particular to Silicon avalanche LEDs.

**BACKGROUND TO THE INVENTION**

It has been recognised that light emission from micron dimensioned silicon devices has numerous potential, as it can be used for realising diverse on - chip and free space optical data communication links. Furthermore, it allows utilising simple and inexpensive silicon integrated circuit technology and processing of data in future generation microprocessor chips by optical means with all its advantages. In addition, integrated circuits of the future can be made smarter by integrating sensors at micron level on chip.

In WO 2009/093177 A1 a light emitting silicon device is shown which comprises a body of a semiconductor material. A first junction region is formed in the body between a first region of the body of a first doping kind and a second region of the body of a second doping kind. A second junction region is formed in the body between the second region of the body and a third region of the body of the first doping kind. A terminal arrangement is connected to the body for, in use, reverse biasing the first junction region into a breakdown mode and for forward biasing at least part of the second junction region, to inject carriers towards the first junction region. The device is configured so that a first depletion region associated with the reverse biased first junction region punches through to a second depletion region associated with the forward biased second junction region.

In US 2005/0253136 A1 a method for forming an electroluminescent device is shown. The method comprises providing a type IV semiconductor material substrate, forming a p+/n+ junction in the substrate, and, forming an electroluminescent layer overlying the p+/n+ junction in the substrate.

In US 2009/0121236 A1 a low cost opto coupler is shown which can be made on Silicon On Insulator (SOI) using conventional integrated circuit processing methods. Metal and deposited insulating materials are used to realize a top reflector for directing light generated by a silicon PN junction diode to a silicon PN junction photo diode detector. The light generator or LED can be operated either in the avalanche mode or in the forward mode. Also, side reflectors are described as a means to contain the light to the LED-photo detector pair. Furthermore, a serpentine junction PN silicon LED is described for the avalanche mode of the silicon LED.

US 8,344,394 B1 describes a circuit that includes multiple doped regions in a substrate. A first of the doped regions has a tip proximate to a second of the doped regions and is separated from the second doped region by an intrinsic region to form a P-I-N structure. The circuit also includes first and second electrodes electrically coupled to the first and second doped regions, respectively. The electrodes are configured to supply voltages to the first and second doped regions to reverse bias the P-I-N structure and generate light. The first doped region could include multiple tips, the second doped region could include multiple tips, and each tip of the first doped region could be proximate to one of the tips of the second doped region to form multiple P-I-N structures. The P-I-N structure could also be configured to operate in double avalanche injection conductivity mode with internal positive feedback.

US 2012/153864 A1 describes a p+np+ silicon avalanche light emitting device comprising a first reverse biased junction and a second forward biased junction.

**OBJECTS OF THE INVENTION**

It is an object of the present invention to provide a Silicon avalanche light emitting device, which overcomes, at least partly, the disadvantages associated with existing light emitting devices.

It is further an object of the present invention to provide a Silicon avalanche light emitting device as a low cost, but efficient light emitting device with high intensity light output that can be used for diverse purposes.

It is also an object of the present invention to provide a light emitting device which is both novel and involves an inventive step.

**SUMMARY OF THE INVENTION**

According to one aspect not being part of the present invention, there is provided a silicon pn based device with different dopant and impurity implanted concentrations strategically placed in the device, the pn junction being reverse biased, such that the 650nm optical emission is stimulated and enhanced.

An impurity density strategically may be placed a distance away from the reverse bias excitation zone, such that a high concentration of energized electrons are formed, a second junction placed a strategic distance away from this zone injecting a high density of low energy holes in opposite direction, such that recombination mechanisms and photonic generation processes is stimulated in the interaction zone between the high energy electrons and the low energy holes.

A high impurity zone strategically may be coinciding with the high recombination zone of high energy electrons and low energy holes so as to enhance momentum spreading of both the diffusing carrier species and enhancing the photon generation from the device.

A conduction channel may be fabricated by appropriate semiconductor process technology, so as to enhance the density of both diffusing energetic electrons and diffusing holes and enhancing the photonic generation in the said channel.

According to an aspect of the present invention, there is provided a Silicon avalanche light emitting device as defined in claim 1, comprising a first junction and a second junction, said first junction including a reverse biased excitation zone for injecting high energy carriers in a first direction and said second junction being forward biased so as to inject high density low energy carriers opposite to said first direction, wherein an interaction zone is formed between said first junction and said second junction so as to enhance emission of 650nm photons through interactions between said high energy carriers and said low energy carriers.

The high energy carriers are electrons and the low energy carriers are holes.

The first junction region is formed as a p+n junction.

The second junction region is formed as a np+ junction.

The interaction zone is formed as a weakly doped n-region.

The device is formed as a p+np+ type junction device. The emission of photons may be generated by excitation of electrons utilising the reverse biased first junction pushed into avalanche or near avalanche, exciting carriers along the first conduction band to near zero momentum values followed by lowering of their crystal momentum through scattering of the electrons and further lowering of their crystal momentums to near zero momentum values, followed by recombination with high density low energy holes as available in the valence band, of the same crystal momentum values.

Substantially only electrons may need to be energized in the first conduction band of silicon, preferably to energies of about 3eV or 1.8eV above the energy in the first minimum of the conduction band.

A specific zone of highly energized electrons may be created a certain distance away from the first junction

The second np+ junction may be placed a certain distance away from the highly energized electron zone, and holes injected into this zone from the second np+ junction and by diffusing through a certain piece of lowly doped neutral n region of the junction.

An optimising bias condition is set up for the second np+ junction which will optimise the energy of the diffusing holes such that the recombination probability between electrons is optimised in terms of both electron and hole energies.

The engineering carrier balances and carrier density may be optimised such the densities could be appropriately balanced

A narrow channel or conduction wire may be engineered in order to confine the carrier flow to only certain crystal regions and to increase the density of both the electron and hole carriers.

Further specific zones may be introduced that allow enhanced scattering of both the diffusing electron and hole carriers so as to enhance the recombination probability through momentum spread.

The device operating conditions may be optimised to prevent thermal damage to the active regions of the device by operating at low excitation conditions with junctions not necessarily being pushed into avalanche and hole charge carriers acquiring very low energies.

## DETAILED DESCRIPTION OF THE INVENTION

The invention will now be described in greater detail by way of example with reference to the following drawing in which is shown:

Fig. 1(a)   electron energy distributions of carriers in k-space and energy in Silicon for an applied field of 300kV.cm-1 as obtained from a Monte Carlo simulation studies;

Fig. 1(b) and (c)   electron and hole momentum distributions in k-space in the first Brillouin Zone;

Fig. 2   energy distribution of populations of electrons and holes in the conduction band and valence band of silicon for various excitation conditions, momentum changes, and possible subsequent photonic transitions;

Fig. 3   ionisation characteristics of electrons in silicon;

Fig 4   excited electron and hole densities in a p+n silicon reverse biased junction under low excitation conditions;

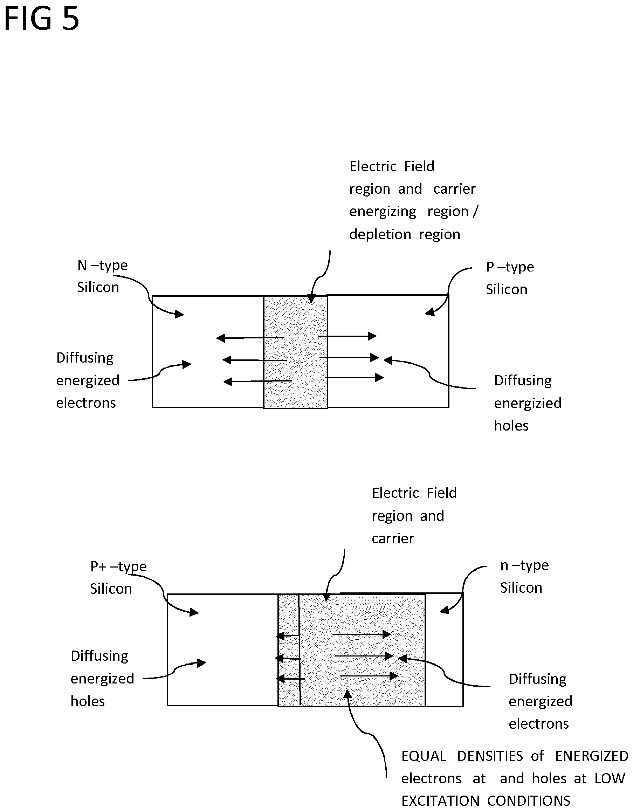

Fig 5.  direction of excitation and diffusion distances in pn silicon reverse biased structures;

Fig. 6(a)  Lateral cross-section of the p+np+ Si Injection Avalanche Si LED;

Fig. 6(b)  Electric field distribution through the device during active bias conditions;

Fig. 6(c)  Conduction cross-section of the device;

Fig. 7  p+np+ device with passive resistive coupling across second junction and with only one voltage bias source;

Fig. 8(a)  Electric field and carrier density profiles for a single p+n abrupt junction Si Av LED, showing unbalanced and minimized scattering of carriers by impurity centers and and Electric field and carrier density profiles for a graded junction p+nn+ Si Av LED showing balanced and maximized energization of carriers followed by maximized scattering of charge carriers in a matrix of positively charged dopant impurity atoms;

Fig 9  observed peaking behaviour in Optical emission versus current curves;

Fig. 10(a)  raw results showing a total spectrum optical power of 600nW as measured for the graded p+np+ junction Si Av LED at 3 mA on a linear scale;

Fig. 10(b)  spectral power (Watts per nm wavelength channel) as measured for the p+nn+, p+n+ overlap and p+nn+ graded junction Si LED devices, respectively; and

Fig 11(a) to (c)  have the same structure as in Fig 6 with an additional thin n+ region.

The inventive device provides for 650nm emission, which is particularly useful for the following reasons. Light can be propagated at relatively low loss through waveguides enabling on chip micro optical links which can be used for future on chip optical communication and optical data processing. 650 mn or 750 nm optical emissions can easily link with existing 1550 nm optical communication systems, mostly operating in off chip systems, since it implies that the frequency of the on-chip carrier has essentially to be halved in order to convert it to 1550nm. The data bandwidth capability of on-chip optical signal processing is effectively doubled when considering the possible modulation frequencies on the high optical carrier. Since simple silicon detectors have very good detectivity down to -90 dBm, it implies that an ample power budget is available in order to realise effective optical links for various purposes. Typically, Si Av LED power to light conversion is -40dBm, insertion losses into waveguides may be -20 dB and detectors has typically -10dB conversion efficiency. This implies that up to 20 dB losses are available in waveguides for a 1 dBm drive system or 30 dB losses for a 10dBm drive system (10V and 1 mA). Typically, losses in micro nitride-based waveguides at 650 nm are of the order of 0.5 dB per cm of chip length. For free space communication applications, insertion losses to the environment can be minimised to -10 dB, which implies that -50 dB are available for free space losses through directional or isotropic propagation mechanisms. Si Av LEDs, with its reverse biased micro device dimensioning show high modulation capability up to 100 GHz or more. It can hence be effectively combined with Si Ge HBT detector structures with a modulation detectivity of up to 30 GHz. Diverse micro optical sensors can be manufactured directly on chip.

Considering all the various mechanisms that can be designed to generate emission from silicon it is believed that the particular mechanism as described in this invention, offers the highest viability in order to generate high intensity emissions. Monte Carlo techniques of carrier energies and momentums in the silicon band structure have been performed when a volume of crystal is subjected to high electric field as experienced in these devices during strong reverse bias conditions. The same physical mechanisms were used for the scattering mechanisms, but the concepts of Monte Carlo techniques were applied in the computer simulations.

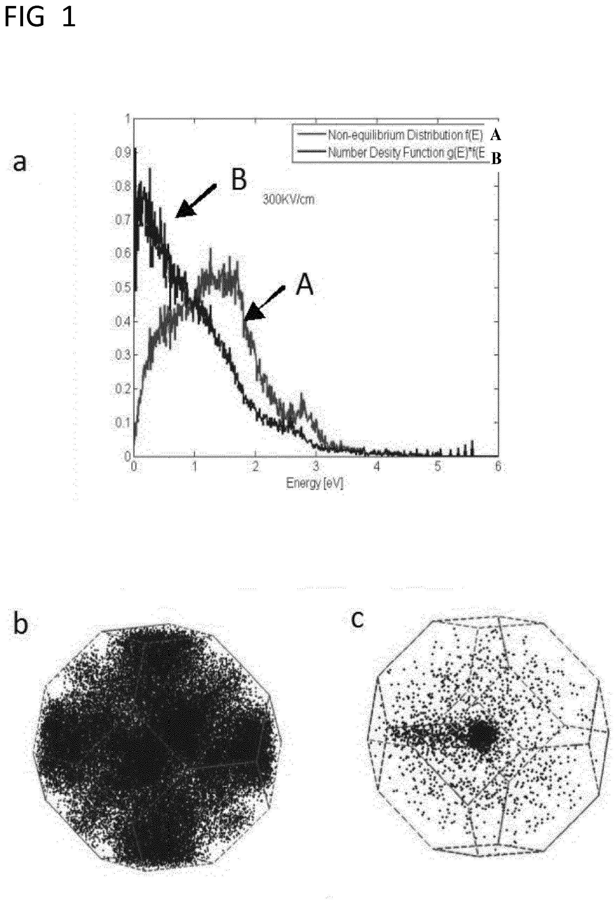

Fig 1 (a) and (b) shows, respectively, the basic energy distribution functions f(E), and for the number density function g(E) f(E) for electrons for impact ionization conditions when excited in an electric field of $3 \times 10^4$ V.cm$^{-1}$. It was observed that the energy distribution of the electrons in the conduction band for this excitation field range from 1.1 to 1.7 eV, while quite a wide momentum scattering is observed for electrons (Fig. 1 (b)). Similar tendencies were observed for holes (Fig. 1 (c)), but the spread in both energy and momentum is lesser due to the heavier effective mass of holes in silicon. A large variation is especially observed for electrons in the first Brillouin zone, implying that electrons acquire a wide variation in momentum values during the lattice scattering processes. Hole momentum values reveal a similar scattering behaviour but at lesser extent and are only channelled in the main E-field and excitation direction.

It follows that by engineering the doping levels of the pn junction and the magnitude of the voltage across the junction, the magnitude of the electric field can be engineered that is responsible for energising the carriers during a reverse bias avalanching situation.

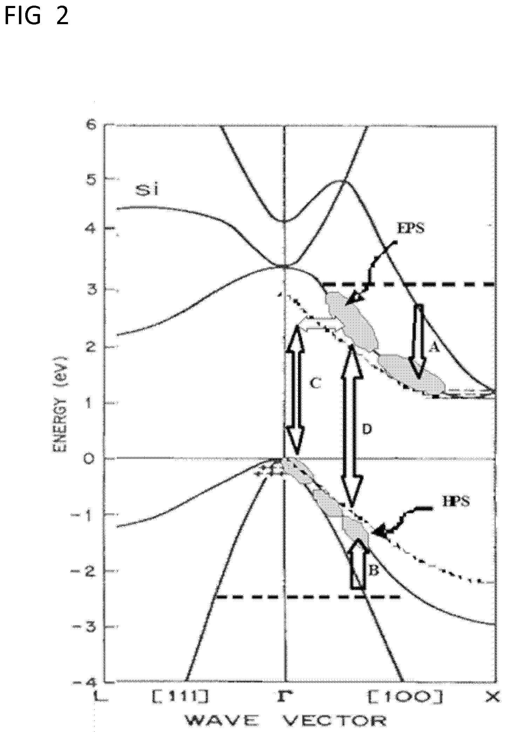

Taking into account the energizing ranges that are available through electric field energizing process, it follows that various "carrier energy populations" can be generated within the energy band structure of silicon. This is schematically illustrated for both electrons and holes in Fig 2 as shaded populations.

By designing different devices, and populating densities of diffusing carriers, and by suitably engineering momentum spread of the carriers during diffusion, it follows that, specific optical transitions can, subsequently, be generated in silicon wavelength emission devices can be generated.

If only electrons are injected into a matrix with no additional carriers injected or generated, only electrons will dissipate energy and momentum changes in a n+ matrix. In such a case it is most probable that only electron energy transitions or relaxations will generate photonic emissions. Comparing the transition energies and the conversion physics as in Fig 2, it is evident that the emissions will mainly be in the long wavelength range, i.e. from a 750nm to 850nm. Wavelength emissions in this wavelength could primarily be utilised in the long wavelength infrared communication applications. It is also suitably for various on chip waveguide applications since the losses in waveguides at these wavelengths are substantially much lower. Similarly, it could be utilised in short range free space communication from micro dimensioned devices at the microchip level.

On the other hand, if populations and momentum distributions of electrons and holes are set up, such that transitions of Type B is primarily set up as in Fig 2, with some momentum assisted transitions, as in the latter publication results, very high emissions of around 650 nm can be generated. This wavelength is still suitable for low loss waveguide propagation on chip and for various free space applications since it is in the red/ infrared zone.

If both electrons and holes are equally generated in equal carrier densities and appropriately populated in the energy band structure, such that momentum values of excited carriers coincide, particular transitions of Type D can be stimulated where very high energy and direct transitions can occur. This emission wavelength will be primarily in the ultra violet wavelength region. As a result of the very high photon energy, it can be anticipated that these photons can be utilised in micro-sensing devices in various application as in the micro - bio and micro- chip sensing and analyses field.

Hence three wavelength emission ranges can, in principle, be generated for these types of Si Av LEDs with emissions primarily being 450nm, 650nm and about 850 nm.

Of these three the 650 nm emission has the highest possibility of being stimulated as will be elucidated in this invention description.

Consideration of all the probable photonic emissions that can be generated in silicon as described above, it is postulated that generation of light emission by excitation of electrons utilising a reverse biased junction pushed into avalanche or near avalanche, exciting carriers along the first conduction band to near zero momentum values followed by lowering of their crystal momentum through scattering of the electrons and further lowering of their crystal momentums to near zero momentum values, followed by recombination with high density low energy holes as available in the valence band, of the same crystal momentum values, this transition offers the potential to yield the highest optical emissions in silicon. These transitions are indicated by Carrier Transition Mechanism C in Fig 2.

In a first part of the invention, mainly only electrons are and need to be energized in the first conduction band of silicon to energies of about 3eV or 1.8eV above the energy in the first minimum of the conduction band.

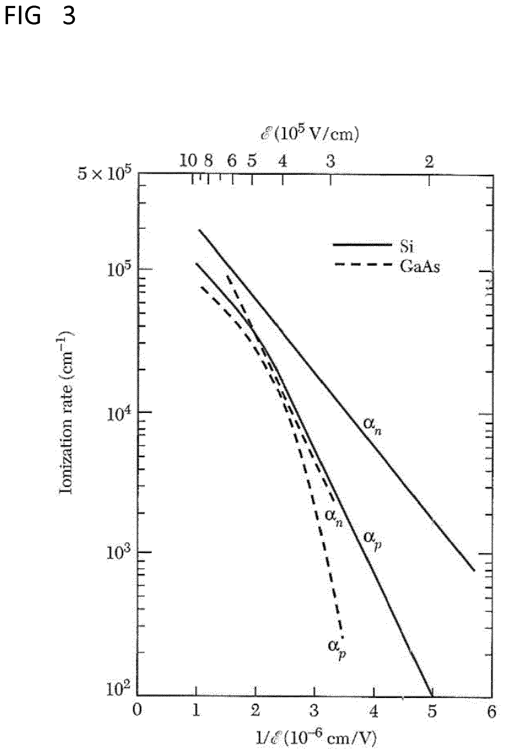

This can be achieved by utilising the physical fact that at low excitation conditions, the ionisation rate for electrons are about 10 times higher than for holes, as depicted in FIG 3.

Applying this phenomenon in an equal dopant density pn junction, it implies that at or near avalanche conditions, a high density of high energy electrons of near 3 eV can be set up on the n-side of the junction, and a certain distance from the pn metallurgical interface as are schematically illustrated in Fig 3. Since the electric field is not high enough in order to ionise a high density of holes, it follows that the high energy holes that were generated from the electron ionisation processes will only diffuse to the opposite side of the junction as illustrated in Fig 2 (b).

Subsequently a specific zone of highly energized electrons can be created a certain distance away from the metallurgical pn junction containing mainly highly energized electrons of about 3eV. This will be roughly equal to about 5 times the average diffusion length of high energy electrons which is of the order of 150nm, which leads to a value of about 0.6 micron.

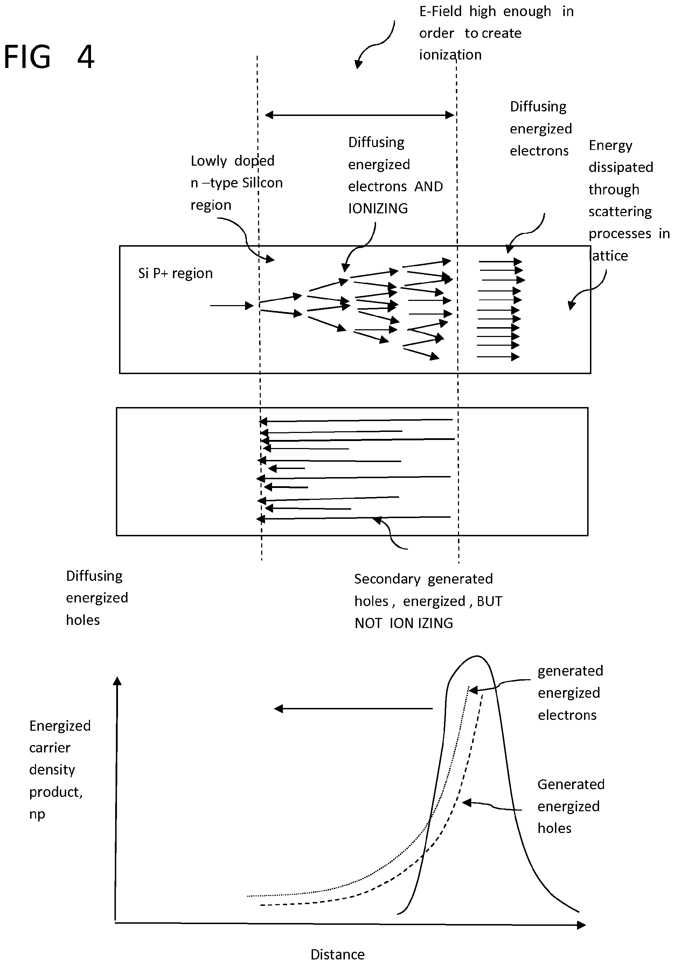

In a p+n junction scenario, where the p-region is highly doped and the n region lowly doped, the depletion layer mainly extends towards the n-side and hence mainly electrons will achieve long diffusion lengths and cause secondary multiplications. This concept is schematically illustrated in Fig 4. Holes will experience high scattering in a thin layer in the p+ region and light emission will only be limited to a very thin layer at the p+ interface.

A second p+ doped region containing a high density of low energy holes is situated at the said zone containing high energy electrons. Hence a zone is set up in the device where a very high recombination of high energy electrons of near zero crystal momentum with low energy holes fulfilling the conditions as set up for photonic transition mechanism C.

However, a second pn junction would offer a potential barrier of 0.7 eV to diffusing electrons which could reduce the energy of the electrons and defeat the recombination purpose. A secondary requirement is hence that the second pn junction should be slightly forward biased with about 0.7 V in order to reduce such barrier.

The second pn junction could be placed a certain distance away from the energized electron zone, and holes injected into this zone from the second p+n junction and by diffusing through a certain piece of lowly doped neutral n region of the junction. it should however be ensured that the holes do not acquire high energy since this will push hole energies down in the valence band and defeat high intensity recombination according to transition mechanism C. Also, the opposite diffusion flux that high energy electrons will see can also reduce the acquired high energy of diffusing electrons.

An optimising bias condition is set up for the second np+ junction which will optimise the energy of the diffusing holes such that the recombination probability between electrons is optimised in terms of both electron and hole energies. A peaking behaviour with a high peak in optical emission intensity will be observed for such conditions.

The engineering carrier balances and carrier density is optimised in order to increase photonic emissions according to transition mechanism C.

The magnitude of the optical magnitude emission intensity will be a function of the product of the respective carrier densities through

$$R = C \, n' \, p'$$

where n' is the density of the energized electrons and p' the localized hole density of specifically engineered energy, and C is a proportionality constant.

It follows, that if (1) carrier densities of the diffusing electrons and holes could be significantly increased per unit volume of the silicon crystal, and (2) if the densities could be appropriately balanced by engineering the densities to be equal, the photonic emissions from silicon can be significantly increased.

This could be achieved by facilitating or engineering a narrow channel or conduction wire in order to confine the carrier flow to only certain crystal regions and to increase the density of both the electron and hole carriers.

Further specific zones can be introduced in the above device that will allow enhances scattering of both the diffusing electron and hole carriers. This scattering of the high energy electrons will cause a momentum change or a momentum spread in the crystal momentum as associated with the diffusing energetic electrons. Such momentum spread may enhance the recombination probability in the photonic generation mechanism C as depicted in FIG 2. Creating a lateral momentum change of the carriers in the band structure, will considerably enhance the photonic recombination probability according to mechanism C.

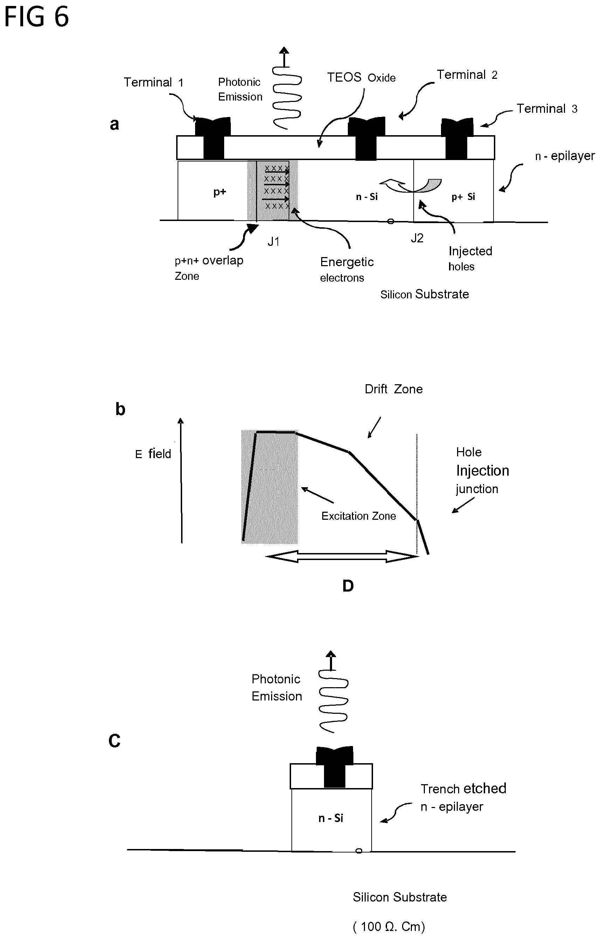

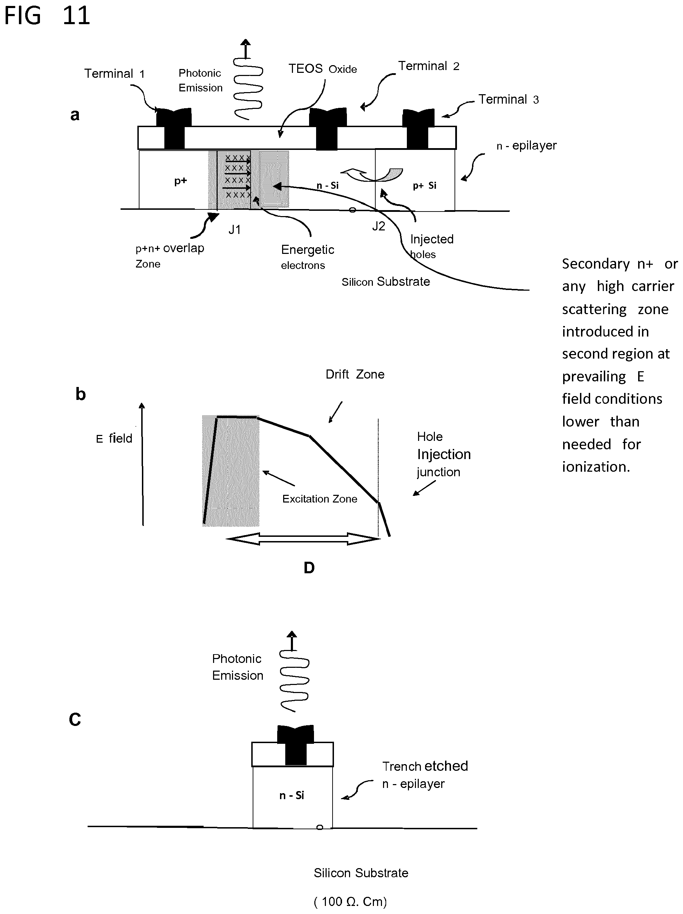

Such regions could be easily built into the junction using implantation techniques using foreign neutral species or by introducing adjacently lying surface scattering zones near to the intended recombination zones. A preferred embodiment of this concept is shown in Fig 11, where the same structure as in Fig. 6 are used but an additional thin n+ region containing a high density of phosphorous dopants are introduced in order to enhance scattering of the exited electrons diffusing through this region at lower E field prevailing conditions and interacting with an opposite flux of injected low energy holes. This high scattering zone can be created optionally also by means of implantation techniques using more neutral implantation species or even Si -Si O2 diffusion in order to create a zone of high scattering centres mostly of interface defect nature in order enhance scattering of the diffusing high energy electrons and lower energy holes.

The above device operating conditions can be optimised to prevent thermal damage to the active regions of the device. Hot carrier devices with junction s pushed into hard avalanche, often create excessive high energy and high densities of energetic electrons and holes with hot holes carrying most of the energy because of their larger mass. This can cause severe damage to crystal structures and sensitive material sections of the device.

In the above designed as in this invention, the device operates at low excitation conditions with junctions not necessarily being pushed into avalanche and hole charge carriers acquiring very low energies. These features make the device extremely viable as high photon generating device with almost no degradation with time, and ensuring a long lifetime and low secondary hot carrier effects.

Also, it would enable the same device to be used as a detector structure with no damage being done to the detecting junction due to prior operation as a hot carrier device. Degradation effects in the detection capability of pn junctions that have been placed in avalanche mode of operation have been commonly observed. Hot carrier devices are normally known in the semiconductor industry to cause undesirable effects and inconsistencies in long term device behaviour and device reliability. Semiconductor designers hence normally steer away from hot carrier devices.

In the following, a first embodiment of the invention will be described with respect to a p+np+ device.

Specific p+np+ type junction devices can be designed in this study as in Fig. 6 using a 0.35 micron Si bi-polar process with a high frequency RF application capability. This process enabled "elongated pillar" of columnar structures to be etched out on a broad lower lying silicon semi-insulating p-substrate. These structures could hence effectively confine the lateral carrier diffusion and maximized the diffusing carrier density along the structures. A thin p+n+ overlap region was defined just adjacent to the p+ region. The purpose of this region was to create a thin region of net low n doped region, but containing exceptional high dopant impurity content. Such a region then could hence sustain a high electric field, but simultaneously also provide a very high scattering zone for the excited carriers. A second p+ region was placed nearby in the n epi-layer, with the purpose to be forward biased and to inject low energy holes into the avalanching light emitting junction. The dimension of each block of the columnar structure was of about one micron dimension each. The total device conduction cross-sectional conduction area was about 1 $\mu m^2$. Appropriate contacts were processed on high doping section with third contact strategically contacting the middle n region. The first junction of the device was reverse biased, until carries electrons undergo ionization processes. Ionization of both electrons and holes occur in the high impurity low doped n- region of the device. However, since the ratio in silicon is ten times higher for electrons than holes at low excitation conditions, mainly electrons are excited and traverse towards the n region of the device.

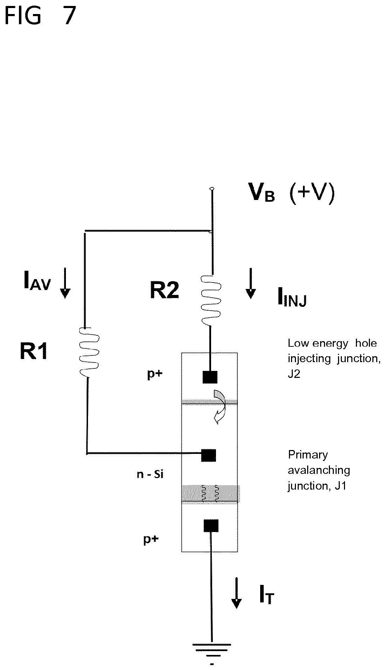

The bias voltage to the centre n-region (Terminal 2) hence facilitated control of the level of excitation in the first reverse biased junction. Similarly, by applying bias voltage on Terminal 3, the second np+ junction in the structure could be forward bias such that holes are injected into the avalanching junction. Since the distance from the second np+ junction is small, the injected hole energies that reaches the n low doping region stays high. By placing so called "bias resistors" in the device biasing circuit, as schematically illustrated in Fig 7, the particular mix of carriers traversing the transition region, D, could be controlled. For example, by selecting R1 zero and R2 infinitely high, only the J1 would be reverse biased and only avalanche current (mainly electrons) would be administered in the primary junction, J1. Similarly, if forward bias voltage is administered across J2, a current density or certain portion of "injected holes" may reach the avalanching junction. If R2 goes to very high values, a very high density of, mainly, holes would be traversing the junction J1.

This procedure implies that the light emission characteristics from the device could be studied as a function of current magnitude, carrier type, and carrier mixing traversing the avalanching junction. Since the values of the resistors are known and measuring the voltage across each resistor, the avalanche and hole injection component could be calculated in each case, and compared with the total device current, IT, flowing through the device.

It should be mentioned also that as the bias voltage on Terminal 2 increases to high values, both high densities of electrons and holes would be excited in the excitation zone, and the hole energy distribution would also get more distributed. Thus, it would make sense, to carefully the effect of the low energy injected holes, only at lower total device currents, since at low excitation conditions, the excited carriers in the excitation zone are mainly electrons because of the higher ionization coefficient for electrons at these conditions (about ten times higher than holes). Choosing such conditions would enable studying the injection of low energy holes into the light emitting avalanching junction, more accurately.

The optical yield results as measured for the devices were measured with an optical fibre lens-probe with a connected Anritso MS9710B Spectrum Analyser.

In the following, a second embodiment which is not part of the invention will be described with respect to p+nn+ graded junction device.

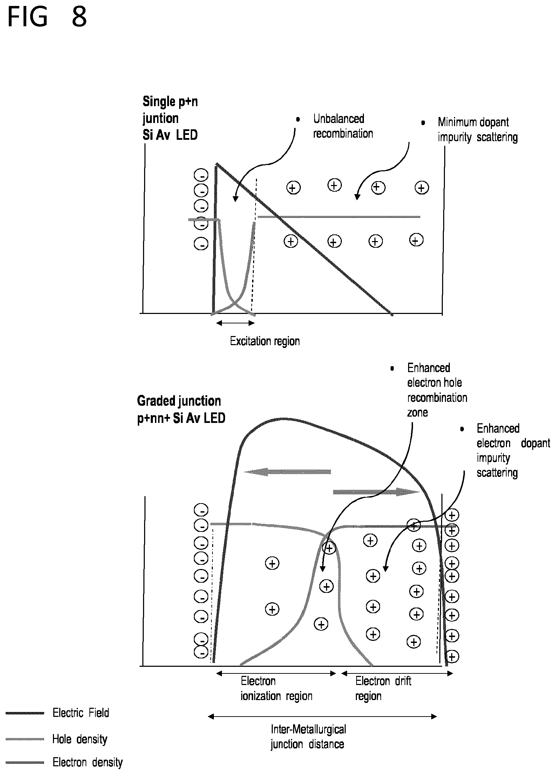

Fig 8 show a modelling scenario for a specially designed p+nn+ junction device, with a specific matrix of positive n impurity dopant density of lower value situated in the centre part of the device. Particularly, a graded junction characteristics is presented here, with the impurity profile increasing towards second "nn+ junction" region.

Particularly noticeable is that a high E field conditions is maintained near the first p+n metallurgical junction. This feature would specifically support carrier ionization and carrier multiplication processes as they occur through normal avalanching processes. Furthermore, by carefully controlling the applied device voltage in this device, a low ionization mode of operation could be set up which would promote ionization and multiplication in electrons per unit crystal length as they diffuse towards the second nn+ metallurgical junction region. At an E field excitation of $2 \times 10^5$ V.cm$^{-1}$, the ionization coefficient for electrons is about ten to twenty-fold higher than for holes in silicon.

Since each multiplication process by an ionizing electron, leads to the generation of a single hole. It follows that hole generated densities of holes will correspondingly scale with electron densities towards the higher n-doped regions. This implies that approximate equal densities of generated electrons and holes are generated in the centre part of the device between the two metallurgical junction areas. The density profiles considerably overlap over a large crystal volume and this scenario could especially promote inter-band electron-hole recombination processes as hypothesized by means of Type C transitions in Fig 2.

Since a matrix of positive dopant impurity atoms are embedded throughout the whole depleted n-region of the device; furthermore, it implies that the crystal momentum for electrons in the silicon may undergo localized momentum changes due to localized scattering processes.

These processes could especially promote both inter-band electron-hole recombination processes of Type C and Type D, as well as intra-band electron hole relaxation and transition processes of Type A and Type B.

It can be anticipated that these processes of Type C and D would occur in the whole of the centre inter-junction region, but processes of Type A and B would especially occur in the large volume electron and hole drift regions where the electric field are lower than electron ionization critical field levels.

It can be anticipated that similar process may also occur for diffusing holes as they diffuse towards the first p+n metallurgical junction, especially if there are also a gradient of impurity dopant atoms also present at this junction. However, since the E-field is much lower towards the second n+p junction region, it can be expected that the generation level of the holes will be lower.

Lastly, it should be realized that carrier transit times in high electric field and short distance reverse biased junctions silicon pn and pin junctions are extremely short. Generally, a high frequency capability up to tens of GHz is predicted.

In conclusion, some brief experimental results are presented in order to proof the validity of this patent description.

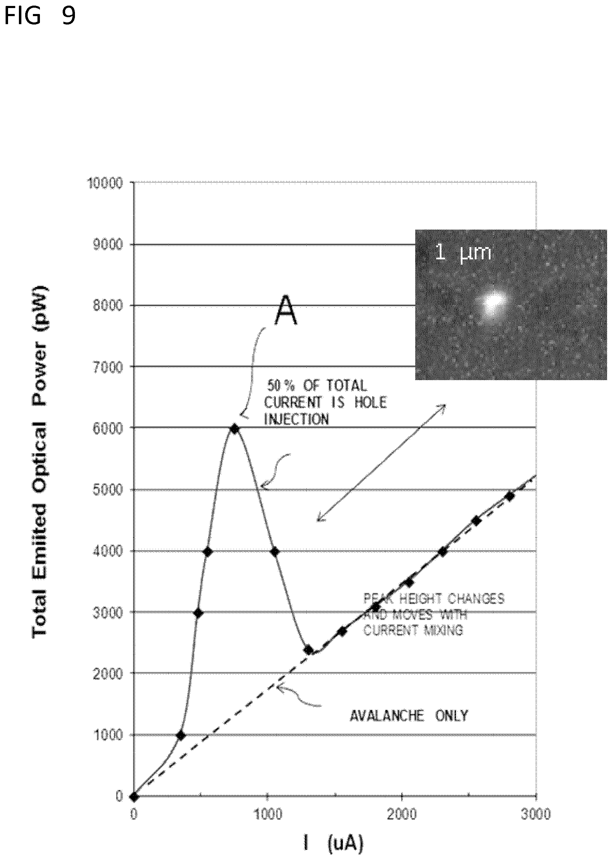

In Fig 9 the output optical emission versus total device current which were biased with a resistive coupling between the second p+ and middle n region and a single negative bias as in Fig on the p+ region is presented. A clear peaking of the output emission curve is shown at mid bias voltage operating condition indicating that a mechanism change occurred in the optical generation mechanism and which basically confirms all the description arguments as presented in section 2 of this patent description.

The optical emission versus current characteristics that are observed for this operation of the device is summarised in Fig 8. An interesting feature occurs in the O-I characteristics of the device showing a clear increase in optical emission intensity at certain bias conditions and current magnitudes. These features can be explained according to the operational aspects as described earlier in the invention description.

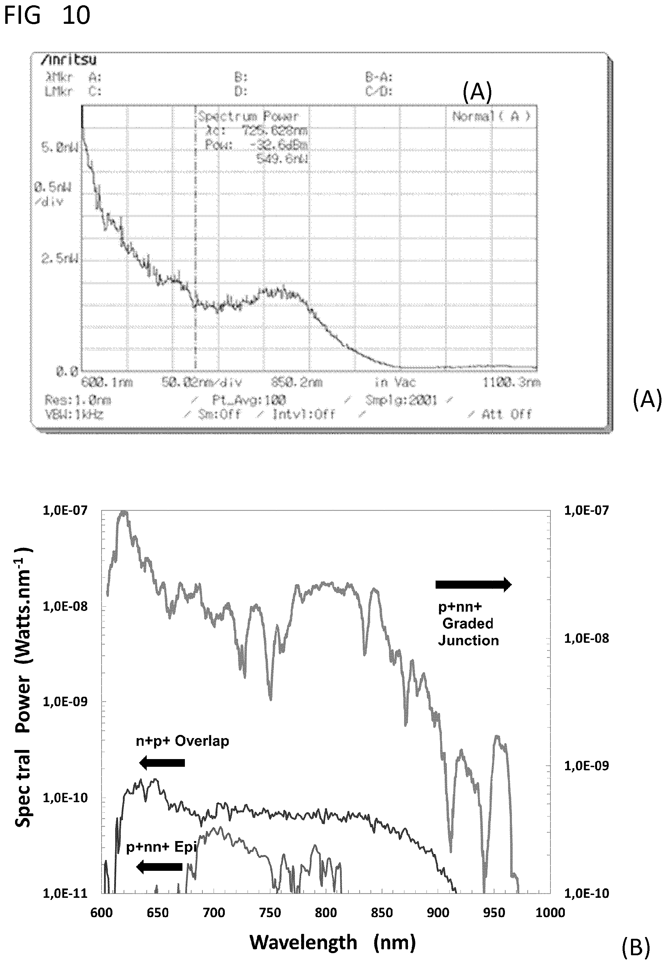

In Fig 10 the output optical emission characteristics are presented in spectral form in both linear and logarithmic forms. Both these curves illustrate about 150-fold increase of the optical emission characteristics at specifically the 650nm emission region. This observation again explicitly confirms the stimulation and optimisation of the photonic generation processes in silicon as elucidated in Section 2 and in Fig 2.

In Fig 11, have the same structure as in Fig 6 with an additional thin n+ region.

This secondary n+ or any high carrier scattering zone introduced in second region at prevailing E field conditions lower than needed for ionization.

The invention is defined by the appended claims.

## Claims

1. A p+np+ type silicon avalanche light emitting device comprising a first p+n junction (J1) and a second np+ junction (J2), said first p+n junction including a reverse biased excitation zone for injecting high energy carriers in a first direction and said second np+ junction being forward biased so as to inject high density low energy carriers opposite to said first direction, wherein an interaction zone is formed as a weakly doped n-region between said first junction and said second junction so as to enhance emission of 650nm photons through interactions between said high energy carriers and said low energy carriers **characterized in that** a thin p+n+ overlap region is added adjacent the p+ region of the first p+n junction providing a scattering zone for excited carriers , and **in that** the device comprises a terminal contacting the interaction zone and adapted to apply a bias voltage to said interaction zone.

2. The silicon avalanche light emitting device as claimed in claim 1, wherein the high energy carriers are electrons and the low energy carriers are holes.

3. The silicon avalanche light emitting device of claim 1 or 2 comprising an additional thin n+ region in the interaction zone.

4. The silicon avalanche light emitting device as claimed in any one of claims 1 to 3, wherein the emission of photons is generated by excitation of electrons utilising the reverse biased first junction pushed into avalanche or near avalanche, exciting carriers along the first conduction band to near zero momentum values followed by lowering of their crystal momentum through scattering of the electrons and further lowering of their crystal momentums to near zero momentum values, followed by recombination with high density low energy holes as available in the valence band, of the same crystal momentum values.

5. The silicon avalanche light emitting device as claimed in claim 4, wherein only electrons need to be energized in the first conduction band of silicon.

6. The silicon avalanche light emitting device as claimed in claim 5, wherein electrons are energized to energies of about 3eV or 1.8eV above the energy in the first minimum of the conduction band.

7.   The silicon avalanche light emitting device as claimed in any one of claims 4 to 6, wherein a specific zone of highly energized electrons is created at a distance away from the first junction

8.   The silicon avalanche light emitting device as claimed in claim 7, wherein the second np+ junction is placed at a distance away from the highly energized electron zone, and holes are injected into this zone from the second np+ junction and by diffusing through a certain piece of lowly doped neutral n region of the junction.

9.   The silicon avalanche light emitting device as claimed in any one of claims 1 to 8, wherein a bias condition is set up for the second np+ junction such that the recombination probability between electrons is optimised in terms of both electron and hole energies.


**Patentansprüche**

1.   Silizium-Avalanche-Lichtemissionsvorrichtung vom Typ p+np+, die einen ersten p+n Übergang (J1) und einen zweiten np+ Übergang (J2) aufweist, wobei der erste p+n Übergang eine rückwärts vorgespannte Anregungszone zum Injizieren von Hochenergie-Ladungsträgern in eine erste Richtung umfasst und der zweite np+ Übergang in Vorwärtsrichtung vorgespannt ist, um Niedrigenergie-Ladungsträger hoher Dichte, die der ersten Richtung entgegengesetzt sind, zu injizieren, wobei eine Interaktionszone als schwach dotierter n-Bereich zwischen dem ersten Übergang und dem zweiten Übergang ausgebildet ist, um die Emission von 650 nm Photonen durch Wechselwirkungen zwischen den Hochenergie-Ladungsträgern und den Niedrigenergie-Ladungsträgern zu verbessern, **dadurch gekennzeichnet, dass** ein schmaler p+n+ Überschneidungsbereich, angrenzend an den p+ Bereich des ersten p+n Übergangs, hinzugefügt wird, wodurch eine Streuzone für angeregte Ladungsträger geschaffen wird, und dadurch, dass die Vorrichtung ein Terminal aufweist, das die Interaktionszone kontaktiert und zur Beaufschlagung der Interaktionszone mit einer Vorspannung angepasst ist.

2.   Silizium-Avalanche-Lichtemissionsvorrichtung gemäß Anspruch 1, wobei die Hochenergie-Ladungsträger Elektronen und die Niedrigenergie-Ladungsträger Löcher sind.

3.   Silizium-Avalanche-Lichtemissionsvorrichtung gemäß Anspruch 1 oder 2, die einen zusätzlichen schmalen n+ Bereich in der Interaktionszone aufweist.

4.   Silizium-Avalanche-Lichtemissionsvorrichtung gemäß einem der vorhergehenden Ansprüche 1 bis 3, wobei die Emission von Photonen durch Anregung von Elektronen erzeugt wird, die den rückwärts vorgespannten ersten Übergang nutzen, der in Avalanche oder Avalanche-Nähe gedrängt wird, wobei Ladungsträger entlang des ersten Leitungsbandes zu Impulswerten nahe Null angeregt werden, gefolgt von einer Absenkung ihres Kristallimpulses durch Streuung der Elektronen und des weiteren Absenkens ihrer Kristallimpulse auf - Impulswerte nahe Null, gefolgt von einer Rekombination mit Niedrigenergielöchern hoher Dichte, wie sie im Valenzband verfügbar sind, mit den gleichen Kristallimpulswerten.

5.   Silizium-Avalanche-Lichtemissionsvorrichtung gemäß Anspruch 4, wobei nur Elektronen im ersten Leitungsband von Silizium mit Energie versorgt werden müssen.

6.   Silizium-Avalanche-Lichtemissionsvorrichtung gemäß Anspruch 5, wobei Elektronen auf Energien von etwa 3eV oder 1.8eV oberhalb der Energie im ersten Minimum des Leitungsbandes mit Energie versorgt werden müssen.

7.   Silizium-Avalanche-Lichtemissionsvorrichtung gemäß einem der Ansprüche 4 bis 6, wobei eine spezifische Zone hochenergetischer Elektronen im Abstand zum ersten Übergang erzeugt wird.

8.   Silizium-Avalanche-Lichtemissionsvorrichtung gemäß Anspruch 7, wobei der zweite np+ Übergang im Abstand zur hochenergetischen Elektronenzone angeordnet ist, und Löcher vom zweiten np+ Übergang in diese Zone injiziert werden, und durch Diffundieren durch ein bestimmtes Stück des schwach dotierten neutralen n-Bereichs des Übergangs.

9.   Silizium-Avalanche-Lichtemissionsvorrichtung gemäß einem der Ansprüche 1 bis 8, wobei eine Vorspannungsbedingung für den zweiten np+ Übergang eingerichtet ist, so dass die Rekombinationswahrscheinlichkeit zwischen Elektronen sowohl hinsichtlich Elektronen- als auch Lochenergien optimiert wird.

**Revendications**

1. Dispositif électroluminescent à avalanche au silicium de type p+np+ comprenant une première jonction p+n (J1) et une seconde jonction np+ (J2), ladite première jonction comprenant une zone d'excitation polarisée en sens inverse pour injecter des porteurs de charge à haute énergie dans une première direction et ladite seconde jonction étant polarisée en sens direct de façon à injecter des porteurs de charge à faible énergie de haute densité à l'opposé de ladite première direction, une zone d'interaction étant formée en tant que région n faiblement dopée entre ladite première jonction et ladite seconde jonction de façon à améliorer l'émission de photons de 650 nm par des interactions entre lesdits porteurs de charge à haute énergie et lesdits porteurs de charge à faible énergie, **caractérisé en ce qu'**une zone mince de chevauchement p+n+ est rajoutée, adjacente à la région p+ de la première jonction p+n, fournissant ainsi à des porteurs de charge excités une zone de diffusion, et **en ce que** le dispositif comprend un terminal se mettant en contact avec la zone d'interaction, adapté de manière à appliquer une tension de polarisation à ladite zone d'interaction.

2. Dispositif électroluminescent à avalanche au silicium selon la revendication 1, dans lequel les porteurs de charge à haute énergie sont des électrons et les porteurs de charge à faible énergie sont des trous.

3. Dispositif électroluminescent à avalanche au silicium selon les revendications 1 ou 2, comprenant une région n+ supplémentaire mince dans la zone d'interaction.

4. Dispositif électroluminescent à avalanche au silicium selon l'une quelconque des revendications 1 à 3, dans lequel l'émission des photons est générée par excitation d'électrons à l'aide de la première jonction polarisée en sens inverse, poussée en avalanche ou en avalanche proche, excitant des porteurs de charge le long de la première bande de conduction jusqu'à des valeurs de moment proches de zéro, suivie par l'abaissement de leur moment cristallin par diffusion des électrons et l'abaissement supplémentaire de leurs moments cristallins à des valeurs de moment proches de zéro, suivie d'une recombinaison avec des trous à faible énergie de haute densité tels que disponibles dans la bande de valence, avec les mêmes valeurs de moment cristallin.

5. Dispositif électroluminescent à avalanche au silicium selon la revendication 4, dans lequel uniquement les électrons doivent être excités dans la première bande de conduction de silicium.

6. Dispositif électroluminescent à avalanche au silicium selon la revendication 5, dans lequel les électrons sont excités à des niveaux d'énergie d'environ 3eV ou 1.8eV au-dessus du niveau d'énergie dans le premier minimum de la bande de conduction.

7. Dispositif électroluminescent à avalanche au silicium selon l'une quelconque des revendications 4 à 6, dans lequel une zone spécifique d'électrons fortement excités est créée à une certaine distance de la première jonction.

8. Dispositif électroluminescent à avalanche au silicium selon la revendication 7, dans lequel la seconde jonction np+ est placée à une certaine distance de la zone d'électrons fortement excités, et des trous sont injectés dans cette zone à partir de la seconde jonction np+ et par diffusion à travers une certaine pièce de la région n neutre, faiblement dopée, de la jonction.

9. Dispositif électroluminescent à avalanche au silicium selon l'une quelconque des revendications 1 à 8, dans lequel une condition de polarisation est établie pour la seconde jonction np+ de telle sorte que la probabilité de recombinaison entre des électrons est optimisée en termes d'énergies d'électrons et de trous.

FIG 1

a

b

c

FIG 2

FIG 3

FIG 4

E-Field high enough in order to create ionization

Lowly doped n –type Silicon region

Diffusing energized electrons AND IONIZING

Diffusing energized electrons

Energy dissipated through scattering processes in lattice

Si P+ region

Diffusing energized holes

Secondary generated holes , energized , BUT NOT ION IZING

Energized carrier density product, np

generated energized electrons

Generated energized holes

Distance

# FIG 5

Electric Field
region and carrier
energizing region /
depletion region

N –type
Silicon

P –type
Silicon

Diffusing
energized
electrons

Diffusing
energizied
holes

Electric Field
region and
carrier

P+ –type
Silicon

n –type
Silicon

Diffusing
energized
holes

Diffusing
energized
electrons

EQUAL DENSITIES of ENERGIZED
electrons at and holes at LOW
EXCITATION CONDITIONS

# FIG 6

**a**

Terminal 1   Photonic Emission   TEOS Oxide   Terminal 2   Terminal 3

n - epilayer

p+     XXXX XXXX XXXX XXXX     n - Si     p+ Si

J1     J2

p+n+ overlap Zone     Energetic electrons     Injected holes

Silicon Substrate

**b**

Drift Zone

E field

Excitation Zone

Hole **Injection** junction

D

**C**

Photonic Emission

Trench etched n - epilayer

n - Si

Silicon Substrate

( 100 Ω. Cm)

FIG 7

$V_B$ (+V)

$I_{AV}$

R2          $I_{INJ}$

R1

p+          Low energy hole
            injecting junction,
            J2

n - Si      Primary
            avalanching
            junction, J1

p+

$I_T$

# FIG 8

**Single p+n juntion Si Av LED**

- Unbalanced recombination
- Minimum dopant impurity scattering

Excitation region

**Graded junction p+nn+ Si Av LED**

- Enhanced electron hole recombination zone
- Enhanced electron dopant impurity scattering

Electron ionization region

Electron drift region

Inter-Metallurgical junction distance

——— Electric Field

~~~~~ Hole density

▬▬▬ Electron density

FIG 9

FIG 10

(A)

(A)

(B)

# FIG 11

**a**

Terminal 1    Photonic Emission    TEOS Oxide    Terminal 2    Terminal 3    n - epilayer

p+    J1    n - Si    p+ Si

p+n+ overlap Zone    Energetic electrons    Injected holes    J2

Silicon Substrate

Secondary n+ or any high carrier scattering zone introduced in second region at prevailing E field conditions lower than needed for ionization.

**b**

Drift Zone

E field    Excitation Zone    Hole Injection junction

D

**C**

Photonic Emission

n - Si    Trench etched n - epilayer

Silicon Substrate

( 100 Ω. Cm)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2009093177 A1
- US 20050253136 A1
- US 20090121236 A1
- US 8344394 B1
- US 2012153864 A1